# EUROPEAN PATENT SPECIFICATION

(11) **EP 3 582 317 B1**
(45) Date of publication and mention of the grant of the patent: **17.04.2024**
(21) Application number: 18845679.2
(22) Date of filing: 09.08.2018
(51) Int. Cl.: H01M 10/42, H05K 13/04, H02J 7/00

(54) **CUSTOMIZED BMS MODULE AND DESIGN METHOD THEREFOR**
KUNDENSPEZIFISCHES BMS-MODUL UND ENTWURFSVERFAHREN DAFÜR
MODULE BMS PERSONNALISÉ ET SON PROCÉDÉ DE CONCEPTION

(30) Priority: 18.08.2017 KR 20170104786
(43) Date of publication of application: 18.12.2019
(73) Proprietor: LG Energy Solution, Ltd., Seoul 07335 (KR)
(72) Inventor: KO, Dong Wan, Daejeon 34122 (KR); LEE, Ki Young, Daejeon 34122 (KR)
(74) Representative: Hoffmann Eitle
(86) International application number: PCT/KR2018/009067
(87) International publication number: WO 2019/035596

(56) References cited:
- WO-A1-2016/060694
- KR-A- 20100 097 504
- KR-A- 20130 014 978
- KR-A- 20130 125 906
- KR-A- 20140 067 754
- KR-A- 20160 061 721
- KR-A- 20160 069 397

## Description

### [Technical Field]

This application claims priority to and the benefit of Korean Patent Application No. 10-2017-0104786 filed in the Korean Intellectual Property Office on August 18, 2017.

The present invention relates to a customized battery management system (BMS) module and a design method therefor, and more particularly, to a customized BMS module, in which a BMS is separated into parts based on a function and is designed in advance, and a BMS part is selected and is mounted on a substrate so as to correspond to a separate BMS design request, without differently designing the BMS in accordance with different component specifications every time, so that it is possible to achieve standardization of the component and to decrease prime cost, verification cost consumed due to a development of a new circuit, and a development time, and a design method therefor.

### [Background Art]

Paten document WO 2016/060694 A1 discloses a battery management system that monitors and reports on an operational state of a battery. Patent document KR 2014 0067754 a BMS including cell balancing circuits arranged as the array shape.

In general, a battery, that is, a secondary battery, used in an electric vehicle (EV), a hybrid vehicle (HV), and for family use or an industry use has high easiness of application according to a product group and has an electric characteristic, such as high energy density, and the like.

The secondary battery attracts attention as a new energy source for improving environment-friendly and energy efficiency in that it is possible to innovatively decrease use of fossil energy, which is the primary advantage, and a by-product according to the use of energy is not generated at all.

In this case, when each of the plurality of secondary batteries is alternately charged and discharged, it is necessary to manage the plurality of secondary batteries by efficiently controlling the charging/discharging so that the battery maintains an appropriate operation state and performance, and to this end, a state and performance of the battery are managed by using a battery management system (BMS), and the BMS serves to measure a current, a voltage, a temperature, and the like of the battery, estimate a state of charging (SOC) of the battery based on the measured current, voltage, temperature, and the like, and control an SOC so as to obtain best fuel consumption efficiency.

In the meantime, in the related art, a specification of a component required for each operation task is different, so that it is necessary to differently design the BMS every time when components and a circuit diagram are designed at the time of development of the BMS, which is an obstacle in achieving the standardization of the component, and is actually a reason causing problems, such as an increase in component cost, an increase in verification cost consumed due to a development of a new circuit, and an increase in development time.

In this respect, in order to solve various problems and limits generated in the BMS design and development process in the related art, the present inventors developed a customized BMS module, in which a BMS is separated into parts based on a function and is designed in advance, and a BMS part is selected and is mounted on a substrate so as to correspond to a separate BMS design request, without differently designing the BMS in accordance with different component specifications every time, so that it is possible to achieve standardization of the component and to decrease prime cost, verification cost consumed due to a development of a new circuit, and a development time, and a design method therefor.

### [Detailed Description of the Invention]

### [Technical Problem]

The present invention is conceived to solve the foregoing problems, and provides a customized battery management system (BMS) module, in which a BMS is separated into parts based on a function and is designed in advance, and a BMS part is selected and is mounted on a substrate so as to correspond to a separate BMS design request, without differently designing the BMS in accordance with different component specifications every time, so that it is possible to achieve standardization of the component and to decrease prime cost, verification cost consumed due to a development of a new circuit, and a development time, and a design method therefor.

### [Technical Solution]

The present invention provides a customized battery management system (BMS) according to claim 1.

In the BMS design request, a list of selectable BMS part modules among the one or more BMS part modules may be pre-organized.

In a preferred embodiment, the substrate may be a printed circuit board (PCB), a flexible PCB (FPCB), or a breadboard.

The present invention also relates to a method of designing a customized battery management system (BMS) according to claim 3.

### [Advantageous Effects]

According to one aspect of the present invention, a BMS is separated into parts based on a function and is designed in advance, and a BMS part is selected and is mounted on a substrate so as to correspond to a separate BMS design request, without differently designing the BMS in accordance with different component specifications every time, so that it is possible to achieve standardization of the component and to decrease prime cost, verification cost consumed due to a development of a new circuit, and a development time.

### [Brief Description of Drawings]

FIG. 1 is a diagram schematically illustrating a configuration of a customized battery management system (BMS) module 100 according to an exemplary embodiment of the present invention.
FIG. 2 is a diagram illustrating a state in which each of one or more BMS part modules 110 is selected according to different BMS design requests 1 and 2.
FIG. 3 is a flowchart illustrating a method of designing the customized BMS module 100 illustrated in FIG. 1 in order.

### [Best Mode]

Hereinafter, an exemplary embodiment is presented for help understanding of the present invention. However, the exemplary embodiment below is simply provided for easier understanding of the present invention, and the contents of the present invention are not limited by the exemplary embodiment.

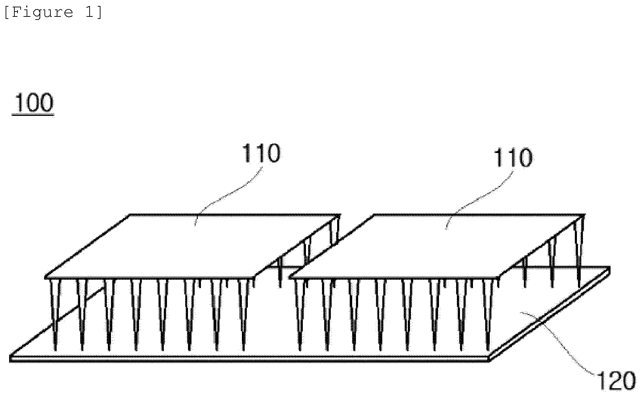

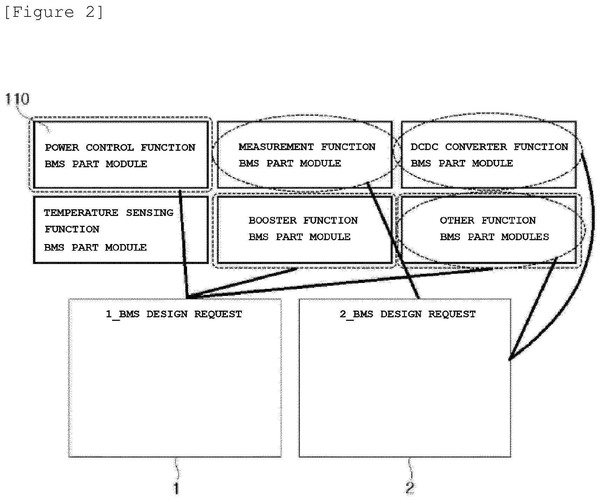

FIG. 1 is a diagram schematically illustrating a configuration of a customized battery management system (BMS) module 100 according to an exemplary embodiment of the present invention, and FIG. 2 is a diagram illustrating a state in which each of the plurality of BMS part modules 110 is selected according to different BMS design requests 1 and 2.

Referring to FIGS. 1 and 2, the customized BMS module 100 according to an exemplary embodiment of the present invention generally includes a plurality of BMS part modules 110 and a substrate 120.

First, the BMS part module 110 means a component (or an element), in which a function-based circuit of the BMS is individually designed and reflected and various functions, such as a power control function, a measurement function, a temperature sensing function, a booster function, and a DCDC converter function of the BMS, performed in the BMS are separately designed based on each function and are reflected to an element.

In this case, one or more pins, which are insertable into pattern recesses provided in the substrate 120, which is to be described below, are provided at one side (for example, a lower side) of the BMS part module 110, and according to the insertion of the pin into the pattern recess, the BMS part module 110 and the substrate 120 are electrically connected with each other and are electrically conducted.

In the meantime, in the BMS, various functions are performed as described above, and the plurality of BMS part modules 110 is also formed so as to correspond to the various functions, and when the plurality of BMS part modules 110 may be designed first, and then may be selectively determined so as to correspond to a separate BMS design request, which will be described with reference to FIG. 2.

Referring to FIG. 2, the BMS performs various functions, such as a power control function, a measurement function, a temperature sensing function, a booster function, and a DCDC converter function, and it can be seen that the plurality of BMS part modules 110 is also designed so as to correspond to various functions.

Particularly, for the first BMS design request, which does not belong to the present invention, (for example, a component specification demanded by user A), the BMS part module corresponding to the power control function, the BMS part module corresponding to the booster function, and the BMS part modules performing other functions may be selected and determined, and for the second BMS design request, which does not belong to the present invention, (for example, a component specification demanded by user B), the BMS part module corresponding to the measurement function, the BMS part module corresponding to the DCDC converter function, and the BMS part modules performing other functions may be selected and determined.

That is, the different BMS part modules 110 may be selectively disposed and mounted on the different substrates 120, respectively, based on the BMS design request, so that it is possible to standardize a component, it is possible to save development time taken according to verification by a development of a new circuit, and it is not necessary to design a new BMS circuit every time which prevents an increase in cost.

Next, the substrate 120 means a region, in which the plurality of BMS part modules 110 are disposed and mounted, and for example, a substrate, such as a printed circuit board (PCB), a flexible PCB (FPCB), or a breadboard, may be applied.

In this case, the patterned pattern recesses are formed at an upper side of the substrate 120, and the pins provided to the BMS part module 110 are inserted into and mounted to the pattern recesses.

Particularly, the pattern recess of the substrate 120 does not have a specific form, but is simply arranged in a repeated pattern, so that the disposition position of the BMS part module 110 may be freely adjusted.

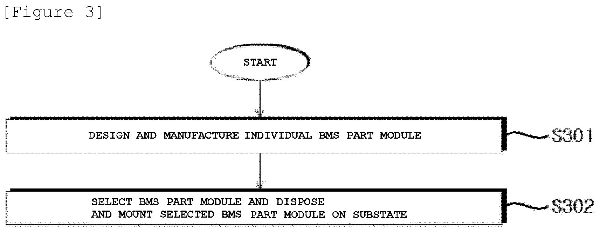

Next, a process of designing the customized BMS module 110 will be sequentially described with reference to FIG. 3.

FIG. 3 is a flowchart illustrating a method of designing the customized BMS module 100 illustrated in FIG. 1 in order.

Referring to FIG. 3, first, a function-based circuit of the BMS is individually designed and reflected to one or more BMS part modules 110 (S301). In this process, in order to correspond to various functions performed by the BMS, the plurality of BMS part modules 110 may be designed.

Next, a plurality of BMS part modules 110 are selectively determined so as to correspond to different BMS design requests and are disposed and mounted onto the substrates 120, respectively (S302). In this case, the pins provided in each BMS part module 110 are inserted to the upper side of the substrate 120, so that the BMS part module 110 and the substrate 120 are electrically connected and conducted.

As described above, according to the present invention, the function-based circuits of the BMS performing various functions are separated, and then are designed and reflected based on each element, and are selectively mounted according to different BMS design requests, so that it is possible to achieve standardization of a component without differently designing the BMS every time in accordance with different component specification, and it is possible to decrease prime cost, decrease verification cost consumed due to a development of a new circuit, and decrease development time.

## Claims

1. A customized battery management system (BMS) module, comprising:
a plurality of BMS part modules, in which function-based circuits of a BMS are individually reflected, wherein the function-based circuits are based on a power control function, a measurement function, a temperature sensing function, a booster function, and a DCDC converter function of the BMS; and
a substrate, on which the plurality of BMS part modules are disposed and mounted,
wherein the plurality of BMS part modules are disposed and mounted onto the substrate,
wherein one or more pins inserted into the substrate are provided in each of the plurality of BMS part modules,
wherein pattern recesses are formed at an upper side of the substrate, the pattern recesses are arranged in a repeated pattern, so that the disposition positions of the BMS part modules are freely adjusted,
wherein pins provided to the BMS part modules are inserted into and mounted to the pattern recesses, and according to the insertion of the pins into the pattern recesses, the BMS part module and the substrate are electrically connected with each other and are electrically conducted.

2. The customized BMS module of claim 1, wherein the substrate is a printed circuit board (PCB), a flexible PCB (FPCB), or a breadboard.

3. A method of designing a customized battery management system (BMS) module, the method comprising:
individually designing and reflecting function-based circuits of a BMS to a plurality of BMS part modules; and
selectively determining the plurality of BMS part modules so as to correspond to a separate BMS design request and disposing and mounting the determined BMS part modules on a substrate,
wherein the function-based circuits are based on a power control function, a measurement function, a temperature sensing function, a booster function, and a DCDC converter function of the BMS,
wherein one or more pins inserted into the substrate are provided in each of the one or more BMS part modules,
wherein pattern recesses are formed at an upper side of the substrate, the pattern recesses are arranged in a repeated pattern, so that the disposition positions of the BMS part modules are freely adjusted,
wherein pins provided to the BMS part modules are inserted into and mounted to the pattern recesses, and according to the insertion of the pins into the pattern recesses, the BMS part module and the substrate are electrically connected with each other and are electrically conducted.

4. The method of claim 3, wherein in the BMS design request, a list of selectable BMS part modules among the plurality of BMS part modules is pre-organized.

5. The method of claim 3, wherein the substrate is a printed circuit board (PCB), a flexible PCB (FPCB), or a breadboard.

## Patentansprüche

1. Kundenspezifisches Batteriemanagementsystem- (BMS) Modul, umfassend:
eine Vielzahl von BMS-Teilmodulen, in denen funktionsbasierte Schaltungen eines BMS individuell reflektiert sind, wobei die funktionsbasierten Schaltungen auf einer Leistungssteuerungsfunktion, einer Messfunktion, einer Temperaturerfassungsfunktion, einer Boosterfunktion und einer DCDC-Wandlerfunktion des BMS basieren; und
ein Substrat, auf dem die Vielzahl von BMS-Teilmodulen angeordnet und montiert ist,
wobei die Vielzahl von BMS-Teilmodulen auf dem Substrat angeordnet und montiert sind,
wobei ein oder mehrere in das Substrat eingeführte Stifte in jedem der Vielzahl von BMS-Teilmodulen bereitgestellt sind,
wobei Musteraussparungen an einer Oberseite des Substrats ausgebildet sind, wobei die Musteraussparungen in einem sich wiederholenden Muster angeordnet sind, so dass die Anordnungspositionen der BMS-Teilmodule frei eingestellt sind,
wobei an den BMS-Teilmodulen bereitgestellte Stifte in die Musteraussparungen eingeführt und daran montiert sind, und entsprechend dem Einführen der Stifte in die Musteraussparungen das BMS-Teilmodul und das Substrat elektrisch miteinander verbunden und elektrisch leitend sind.

2. Kundenspezifisches BMS-Modul nach Anspruch 1, wobei das Substrat eine gedruckte Leiterplatte (PCB), eine flexible Leiterplatte (FPCB) oder eine Steckplatine ist.

3. Entwurfsverfahren für ein kundenspezifisches Batteriemanagementsystem- (BMS) Modul, wobei das Verfahren umfasst:
individuelles Entwerfen und Reflektieren funktionsbasierter Schaltungen eines BMS auf eine Vielzahl von BMS-Teilmodulen; und
selektives Bestimmen der Vielzahl von BMS-Teilmodulen damit sie einer separaten BMS-Entwurfsanfrage entsprechen, und Anordnen und Montieren der bestimmten BMS-Teilmodule auf einem Substrat,
wobei die funktionsbasierten Schaltungen auf einer Leistungssteuerungsfunktion, einer Messfunktion, einer Temperaturerfassungsfunktion, einer Boosterfunktion und einer DCDC-Wandlerfunktion des BMS basieren,
wobei ein oder mehrere in das Substrat eingeführte Stifte in jedem von dem einen oder den mehreren BMS-Teilmodulen bereitgestellt sind,
wobei Musteraussparungen an einer Oberseite des Substrats ausgebildet sind, wobei die Musteraussparungen in einem sich wiederholenden Muster angeordnet sind, so dass die Anordnungspositionen der BMS-Teilmodule frei eingestellt sind,
wobei an den BMS-Teilmodulen bereitgestellte Stifte in die Musteraussparungen eingeführt und daran montiert sind, und entsprechend dem Einführen der Stifte in die Musteraussparungen das BMS-Teilmodul und das Substrat elektrisch miteinander verbunden und elektrisch leitend sind.

4. Verfahren nach Anspruch 3, wobei in der BMS-Entwurfsanfrage eine Liste von auswählbaren BMS-Teilmodulen aus der Vielzahl von BMS-Teilmodulen vororganisiert ist.

5. Verfahren nach Anspruch 3, wobei das Substrat eine gedruckte Leiterplatte (PCB), eine flexible Leiterplatte (FPCB) oder eine Steckplatine ist.

## Revendications

1. Module de système de gestion de batterie (BMS) personnalisé, comprenant :
une pluralité de modules de partie de BMS, dans lesquels des circuits basés sur des fonctions d'un BMS sont individuellement réfléchis, dans lequel les circuits basés sur des fonctions sont basés sur une fonction de commande de puissance, une fonction de mesure, une fonction de détection de température, une fonction d'amplification et une fonction de convertisseur CC-CC du BMS ; et
un substrat, sur lequel la pluralité de modules de partie de BMS sont disposés et montés,
dans lequel la pluralité de modules de partie de BMS sont disposés et montés sur le substrat,
dans lequel une ou plusieurs broches insérées dans le substrat sont fournies dans chacun de la pluralité de modules de partie de BMS,
dans lequel des évidements à motifs sont formés sur un côté supérieur du substrat, les évidements à motifs étant agencés selon un motif répétitif, de sorte que les positions de disposition des modules de partie de BMS soient librement ajustées,
dans lequel des broches disposées sur les modules de parties de BMS sont insérées dans les évidements à motifs et montées sur ceux-ci, et selon l'insertion des broches dans les évidements à motifs, le module de partie de BMS et le substrat sont électriquement connectés l'un à l'autre et sont électroconducteurs.

2. Module de BMS personnalisé selon la revendication 1, dans lequel le substrat est une carte de circuit imprimé (PCB), une PCB souple (FPCB) ou une maquette.

3. Procédé de conception d'un module de système de gestion de batterie (BMS) personnalisé, le procédé comprenant :
la conception et la réflexion individuelles de circuits basés sur des fonctions d'un BMS sur une pluralité de modules de partie de BMS ; et
la détermination sélective de la pluralité de modules de partie de BMS de façon à les faire correspondre à une demande de conception de BMS séparé et la disposition et le montage des modules de partie de BMS déterminés sur un substrat,
dans lequel les circuits basés sur des fonctions sont basés sur une fonction de commande de puissance, une fonction de mesure, une fonction de détection de température, une fonction d'amplification et une fonction de convertisseur CC-CC du BMS, dans lequel une ou plusieurs broches insérées dans le substrat sont fournies dans chacun des un ou plusieurs modules de partie de BMS,
dans lequel des évidements à motifs sont formés sur un côté supérieur du substrat, les évidements à motifs sont agencés selon un motif répétitif, de sorte que les positions de disposition des modules de partie de BMS soient librement ajustées,
dans lequel des broches disposées sur les modules de parties de BMS sont insérées dans les évidements à motifs et montées sur ceux-ci, et selon l'insertion des broches dans les évidements à motifs, le module de partie de BMS et le substrat sont électriquement connectés l'un à l'autre et sont électroconducteurs.

4. Procédé selon la revendication 3, dans lequel dans la demande de conception de BMS, une liste de modules de partie de BMS sélectionnables parmi la pluralité de modules de partie de BMS est pré-organisée.

5. Procédé selon la revendication 3, dans lequel le substrat est une carte de circuit imprimé (PCB), une PCB souple (FPCB) ou une maquette.
